Europäisches Patentamt

European Patent Office

Office européen des brevets

(11) Publication number: **0 184 939**
**B1**

# EUROPEAN PATENT SPECIFICATION

(45) Date of publication of patent specification: **31.10.90**

(51) Int. Cl.⁵: **F 02 D 41/20, H 03 K 17/04**

(21) Application number: **85309046.2**

(22) Date of filing: **12.12.85**

(54) A method of controlling electromagnetic devices and a controller therefor.

(30) Priority: **12.12.84 JP 262233/84**

(43) Date of publication of application:
**18.06.86 Bulletin 86/25**

(45) Publication of the grant of the patent:
**31.10.90 Bulletin 90/44**

(84) Designated Contracting States:
**AT CH DE FR GB LI NL SE**

(56) References cited:
**DE-A-2 262 864
US-A-3 000 069
US-A-3 896 346**

(73) Proprietor: **TECHNOLOGICAL RESEARCH
ASSOCIATION OF HIGHLY RELIABLE MARINE
PROPULSION PLANT
3-8, Mejiro 1-chome Toshima-ku
Tokyo 171 (JP)**

(72) Inventor: **Nagata, Osamu
8-12-503 Kumochicho 1-chome
Chuo-ku Kobe-shi (JP)**
Inventor: **Kajima, Takashi
20-39-302 Kitaoogi 3-chome
Higashinade-ku Kobe-shi (JP)**
Inventor: **Ozaki, Toshiharu
4-15 Sugahara 4-chome
Higashiyodogawa-ku Osaka-shi (JP)**

(74) Representative: **Barnard, Eric Edward et al
BROOKES & MARTIN High Holborn House 52/54
High Holborn
London WC1V 6SE (GB)**

Courier Press, Leamington Spa, England.

# EP 0 184 939 B1

**Description**

The present invention relates to a controller for controlling electromagnetic devices or actuators of the type comprising a body movable by the electromagnetic force of a solenoid coil. Such an actuator can be incorporated in an electromagnetic valve for accurate fuel injection in a diesel engine or an electromagnetic shut off valve, for example.

A known form of controller operates switches of drive means to energise and de-energise a solenoid coil of an electromagnetic device in response to a command signal to cause a movable body be displaced between set positions. The known controller suffers from the disadvantage that it is not possible to energise and de-energise the solenoid coil rapidly because of the inductance of the coil.

A general object of the present invention is to provide an improved form of controller able to enhance the response of the electromagnetic device to changes in the command signal.

US—A—3,896,346 describes a controller of the known type in which here a movable body is displaced by energising a first coil via a direct current source and in response to a change over command signal; said controller comprising a further coil first series circuit means including a first switch, the first coil and a second switch, second series circuit means including a third switch the further coil and a fourth switch, the first and second series means being connected in parallel across the source, third circuit means including a diode connected between the first coil and the further coil and means for controlling the operation of the switches to energise the second circuit means in a chopper mode to cause electromagnetic energy to be stored in the further coil when the first coil is on standby, to transfer energy stored in the further coil to the first coil for a predetermined interval and through the third circuit means when the first coil is to be energised and thereafter to energise the first circuit means in a chopper mode to maintain the energised state of the first coil and to transfer energy stored in the first coil to the further coil for a predetermined time interval when the first coil is to be de-energised.

In accordance with the invention, the energy stored in the first coil is transferred to the further coil through the diode of the third circuit means. Further measures can be adopted to control voltage surges. Thus, a further series circuit can be connected in parallel with the first coil. This further series circuit can comprise a diode of polarity opposite to the direction of the energising current and a nonlinear element which conducts when the back e.m.f. produced by the first coil exceeds a fixed value. A further diode can also be connected in parallel with the further coil and the fourth switch. The invention also provides for stable energy transfer over defined time intervals to protect the circuit from voltage surges.

The control means can comprise comparators which receive inputs representing the currents through the coils and current reference values, timers for providing time delayed signals and a series of logic gates which serve to control the operation of the switches. Edge detectors can detect changes in the command signal and operate the gates and timers.

The invention may be understood more readily and various other important features may become apparent from consideration of the following description.

In the accompanying drawings:

Figure 1 is an electrical circuit diagram of an embodiment of controller in accordance with the present invention;

Figure 2 is a section view of one example of a known electromagnetic device for use with the controller of the present invention;

Figure 3 is an electrical circuit diagram for explaining the operation of the controller shown in Figure 1;

Figure 4 depicts waveforms pertaining to the operation of the controller shown in Figure 1.

Figure 5 is an electrical circuit diagram of a known form of controller; and

Figure 6 depicts waveforms pertaining to the operation of the controller shown in Figure 5.

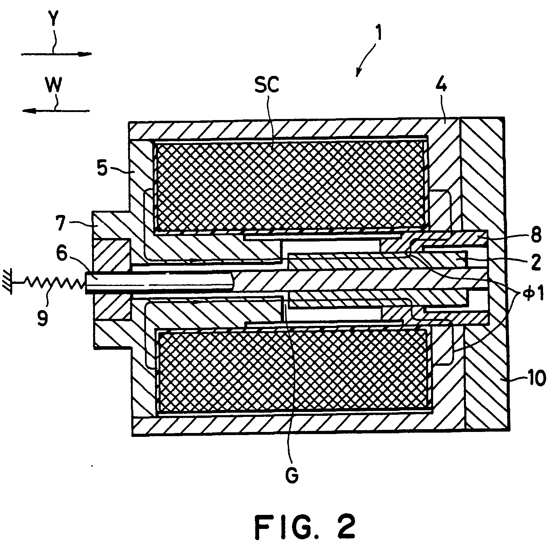

Figure 2 is a sectional view of a typical conventional electromagnetic device or actuator 1. The electromagnetic device 1 has, as basic structural elements, a plunger 2, which is a body movable in an axial direction, a solenoid coil SC wound around the plunger 2, a first yoke 4 and a second yoke 5. The plunger 2 is formed of a ferromagnetic material and is fixed to a shaft 6. Toward the outer end of the shaft 6 (the left end in Figure 2) is provided a bearing 7, and a complementary guide body 8 is provided for the plunger 2. The shaft 6 is fixed at the outer end to a return spring 9, and the other end of the return spring 9 is fixed in position. The right end of the plunger 2 is covered by a lid 10. When the solenoid coil SC is energised the magnetic flux flows as indicated as $\phi 1$ and a magnetic attraction is produced in the magnetic gap G between the second yoke 5 and the plunger 2. The plunger 2 is thereby moved in the direction of the arrow W against the return force of the spring 9. When the energising current is removed from the solenoid coil SC, the magnetic flux disappears, and the electromagnet attraction is dissipated. The plunger 2 is therefore moved in the direction of the arrow Y by the force of the spring 9.

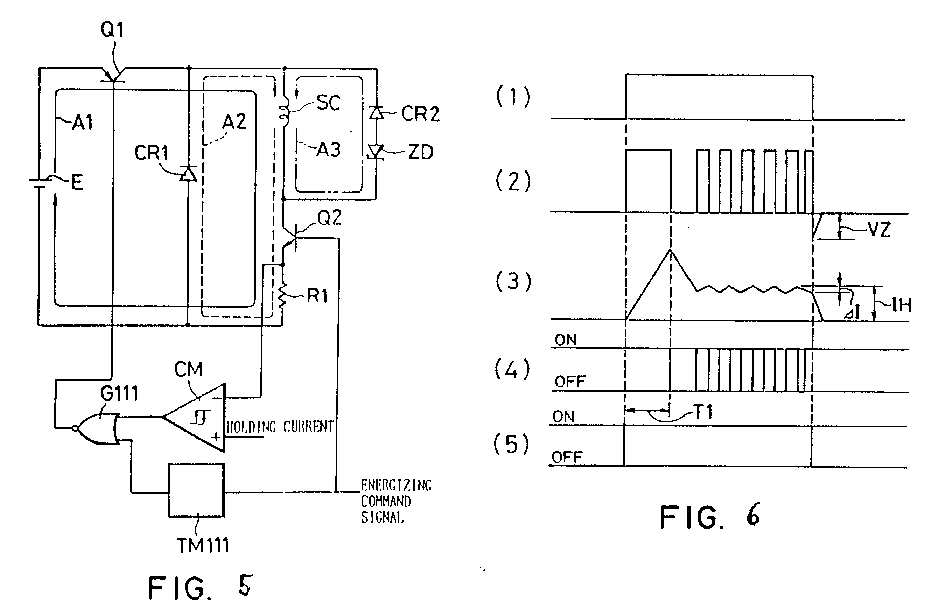

As shown in Figure 5, the coil SC is connected in series with a switching transistor Q2 and a current detecting resistor R1. A voltage E source is connected via a switching transistor Q1 to the series circuit SC, Q2, R1. A diode CR1 is connected across the series circuit SC, Q2, R1 with polarity opposite to the source E. A diode CR2 in series with a Zener diode ZD is connected across the coil SC and the polarity of the diode CR2 is the same as CR1. A comparator CM has inputs connected to the current detecting resistor R1 and to a current reference value holding current and an output connected to one input of an NOR-gate G111. A timer TM111 receives a change-over command signal which determines the position of the movable body or

2

plunger 2 and this command signal also feeds the base of the transistor Q2. The output of the timer TM111 feeds the other input of the NOR-gate G111 and the output of the NOR-gate G111 feeds the base of the transistor Q1.

The operation of the circuit shown in Figure 5 will be explained with reference to Figure 6. In Figure 6, (1) is the energising command signal which commands whether or not the solenoid coil SC is to be energised, (2) is the voltage waveform applied to the coil SC, (3) is the waveform of the current flowing through coil SC, (4) is the operating state of the transistor Q1, and (5) is the operating state of the transistor Q2. When the energising command signal (1) goes from a low level to a high level the transistor Q2 is turned on, (5) and also the timer TM111 operates. As shown in (4) for a set time interval T1 the transistor Q1 is turned on, and current Ie flows in the direction of the solid line arrow A1 in Figure 5 from the direct current supply E through the transistor Q1, the solenoid coil SC, the transistor Q2 and the current detecting resistor R1. The current Ie cannot, because of the inductance of the solenoid coil SC increase instantaneously but increase gradually with time t. If the voltage of the direct current supply E is Ve, and the direct current resistance of the solenoid coil SC is Rs, then the current Ie is given by:

$$Ie = \frac{Ve}{Rs + R1} \left( 1 - e^{-\frac{Rs+R1}{Ls} t} \right) \qquad ...(1)$$

When the time interval T1 of the timer TM111, which is slightly longer than the displacement time of the plunger 2 of the device 1, has elapsed the output of the time TM111 returns to a low level, and as shown in Figure 6 (4) the solenoid coil SC is driven by the output of the comparator CM in chopper mode with the transistor Q1 undergoing repeated on/off operations and at a rated current of the holding current level IH. In this rated current chopper mode, the current level Ie is detected by the current detecting resistor R1, and when it grows larger than the holding current level IH the transistor Q1 goes off and the current Ie flows through the diode CR1 and in the direction of the broken line arrow A2 in Figure 5 and decreases. When the current Ie has become less than the holding current level IH setting by just the hysteresis amplitude ΔI of the comparator, the transistor Q1 again goes on, the current flows in the direction of the solid line arrow A1 in Figure 5, the current Ie increases, and when it becomes larger than the holding current level IH setting, the operation of turning the transistor Q1 off is repeated. In other words, in the rated current chopper mode, by changing the time ratio of the on/off operation of the transistor Q1, the current Ie maintaining the attracting state of the electromagnetic device 1 is made equivalent to the holding current level IH, and is reduced from the current level when the plunger 2 is being moved obtained from the expression (1). The temperature increase of the solenoid coil SC is minimised and the current supply efficiency is increased.

As shown in Figure 6, (1) when the energising command signal goes from a high level to a low level the transistor Q2 goes off, and because of the back e.m.f. produced by the solenoid coil SC the current flows in the direction of the dot-dash arrow A3 in Figure 11 through the Zener diode ZD and the diode CR2, and rapidly dissipates. At this point, if the Zener voltage of the Zener diode ZD is taken as VZ the current Ie is given by:

$$Ie = IH \cdot e^{-\frac{Ls}{Rs} t} - \left( 1 - e^{-\frac{Ls}{Rs} t} \right) \cdot \frac{VZ}{Rs} \qquad ...(2)$$

Also if the maximum surge voltage produced on the collector of transistor Q2 is VP, then this surge voltage VP is given by:

$$VP = VZ + Ve \qquad (3)$$

In other words, the maximum surge voltage VP corresponding to the sum of the maximum Zenor voltage VZ and the supply voltage Ve is applied to the transistor switch Q2. Therefore when the solenoid coil SC is de-energised the higher the Zener voltage VZ the faster it is de-energised, but also the higher the surge voltage VP.

In order to increase the response speed of the electromagnetic device the electromagnetic attraction force when moving the plunger 2 is required to be increased rapidly, but this electromagnetic attraction force is controlled by the current Ie flowing in the solenoid coil SC. Therefore, to move the plunger 2 rapidly, the current Ie flowing in the solenoid coil SC must be increased rapidly, and also when the plunger 2 is returning, the current flowing in the solenoid coil SC must be decreased rapidly in order not to resist the return spring 9. As shown in expression (1) and expression (2), however, abrupt changes of the current Ie are limited by the inductance Ls of the solenoid coil SC, and speeding up of the movement of the plunger 2 is hampered. If when energising the solenoid coil SC the supply voltage Ve is increased, or when de-energising the Zener voltage VZ is increased, then it is possible to speed up the movement of the plunger 2. The result of this, however, is not only that the transistor switches Q1 and Q2 are required to sustain higher voltages, but also that since in the rated current chopper mode the switch on operation time is very short, high speed operation switch elements are required. In order further to increase the supply voltage Ve, it becomes necessary to construct the circuit from diodes and capacitors capable of withstanding high voltage. In practice, there are problems with impaired economy and reliability.

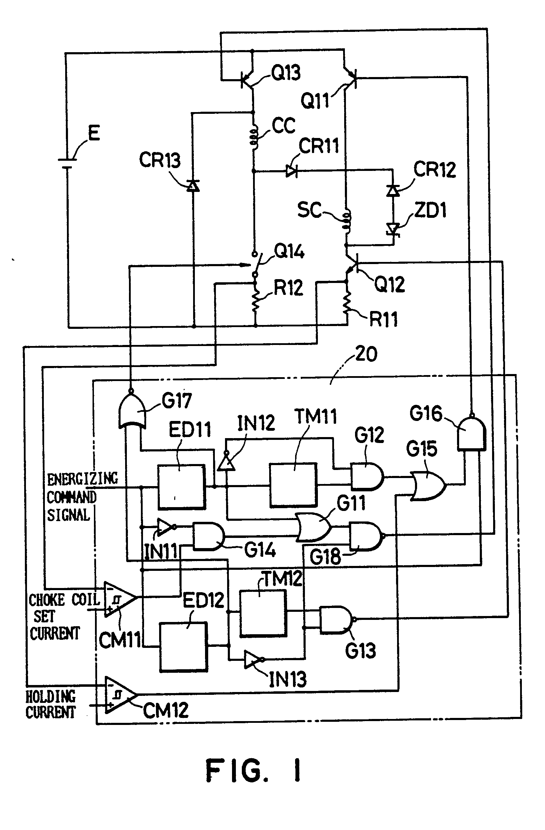

Figure 1 depicts an improved form of controller. As shown in Figure 1, the electromagnetic or solenoid coil SC is in series with transistor switches Q11 and Q12 and a current detecting resistor R11 and is connected directly to the source E. A further series circuit composed of a transistor Q13, a coil CC, an analog switch Q14 and a resistor R112 is also connected across the source E. A diode CR12 and a Zener diode ZD1 are connected across the coil SC. A diode CR11 is connected between the junction of the coil SC and the collector of the transistor Q11 on the one hand and the junction between the coil CC and the Switch Q14 on the other hand. A diode CR13 is connected between the collector of the transistor Q13 and negative terminal of the source E.

The transistors Q11 to Q13 and the analog switch Q14 are controlled by control means 20 composed of comparators CM11, CM12, timers TM11, TM12, edge detectors ED11, ED12 and various logic gates.

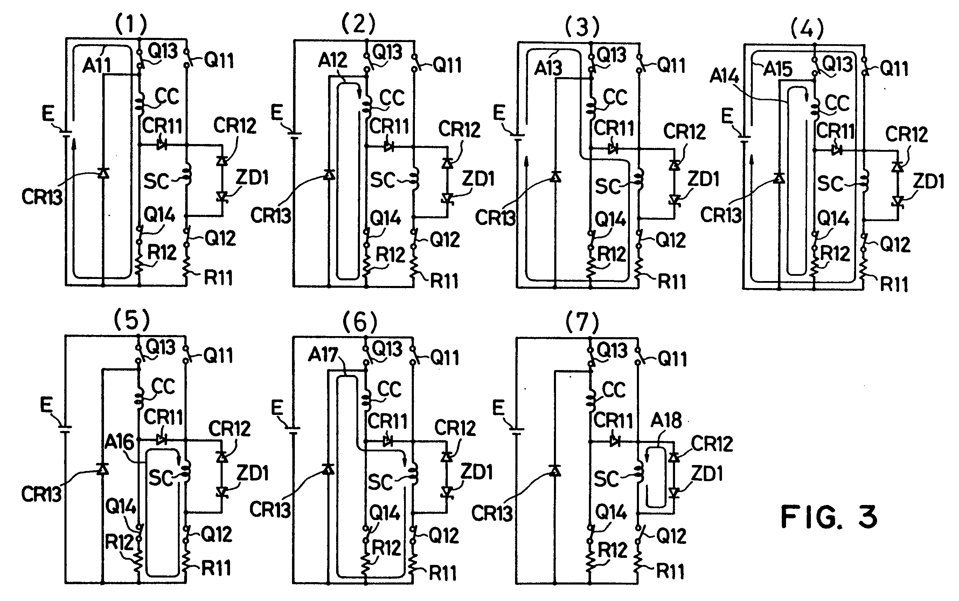

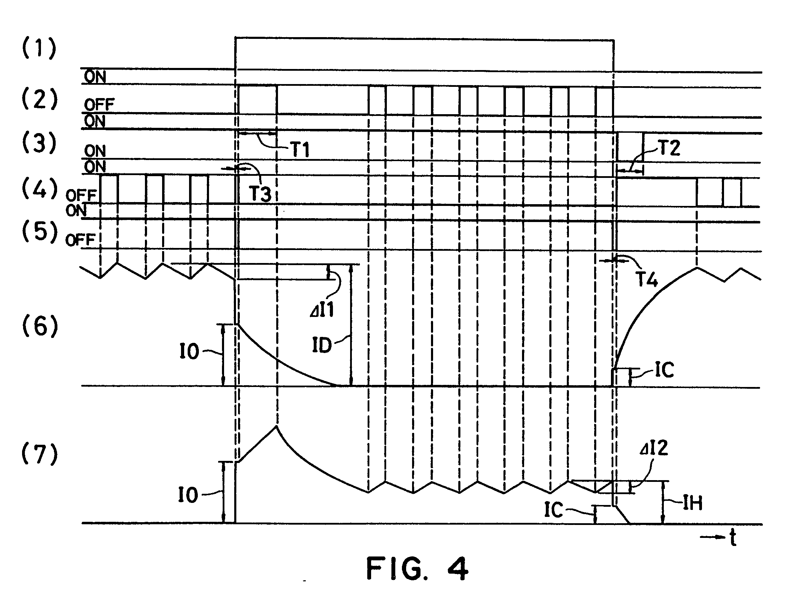

The operation of the controller can be appreciated from Figures 3 and 4. When the energising command signal is at a high level the edge detector ED11 provides a high level signal for the interval T3. When a high level signal is provided to the timer TM11 from the edge detector ED11, a high level signal is present at its output for the time interval T1 and is fed to input of an AND gate G12. When there is a rising or falling change in the energising command signal the edge detector ED12 outputs a high level signal for a time interval T4. The output signal of a NOR gate G17 controls the operation of the switch Q14. When the output is low the switch Q14 is off and when the output is high the switch is on. The output of the gate G17 is low for an interval T3 from a rising edge of the energising command signal and for an interval T4 from a falling edge. When a high level signal is received by the timer TM12 from the edge detector ED12, a high level signal is applied for an interval T2 to one input of a NAND gate G13. The operation of the transistor Q12 is controlled by the output signal of a NAND gate G13. When the output signal of the gate G13 is high the transistor Q12 is turned on, and when low it is turned off. A voltage corresponding to a coil set current level ID for setting the current flowing through the coil Sc is fed to the non-inverting input of a comparator CM11 having hysteresis characteristic with a hysteresis amplitude of I1. To the inverting input of the comparator CM11 is applied a voltage detected by the resistor R12 and corresponding to the current flowing in the coil CC. This input is compared with the voltage corresponding to the current level ID. When the voltage corresponding to the current level ID is higher, the output of the comparator CM11 is high, and when that voltage is lower the output of the comparator CM11 is low. The transistor Q13 is controlled by the output signal of a NAND gate 18, and when the output signal is low the transistor Q13 is turned on, and when low it is turned off. A voltage corresponding to a holding current level IH for setting the current flowing through the solenoid coil SC so that the holding state of the electromagnetic device 1 can be maintained is fed to the non-inverting input of the comparator CM12 having hysteresis characteristic with a hysteresis amplitude of ΔI2. The inverting input of the comparator CM12 receives the voltage detected by the resistor R11. When the voltage corresponding to the current level IH is higher the comparator CM12 has a high level output signal and when that voltage is lower the comparator CM12 has a low level output signal.

Figure 3 illustrates the operation of the controller shown in Figure 1, showing the transistors Q11 to Q13 and the analog switch Q14 as switches and showing the direction of current flow for the different on/off states of the switches Q11 to Q14 while Figure 4 depicts the waveforms. In Figure 4 (1) is the energising command signal, (2) is the on/off state of the switch Q11, (3) is the on/off state of the switch Q12, (4) is the on/off state of the switch Q13, (5) is the on/off state of the switch Q14, (6) is the current waveform flowing through the coil CC, and (7) is the current waveform flowing through the solenoid coil SC. The operation of the circuit will now be explained with reference to Figure 3 and Figure 4. When, as shown in Figure 4 (1), the energising command signal is low the solenoid coil SC is not energised. As shown in Figure 3 (1) when the switch Q11 is in the off state, and switches Q12, Q13 and Q14 are in the on state, current flows from the direct current supply E through the coil CC in the direction shown by the arrow A11. The current flowing through the coil CC is detected by the current detecting resistor R12, and when it reaches the predetermined current level ID, the switch Q13 goes off, current flows in the direction of the arrow A12 in Fig. 3 (2) through the diode CR13. The electromagnetic energy of the coil CC is then dissipated in the direct current resistance component in this closed circuit, and the current flowing in the coil CC progressively decreases. When it becomes lower than the set current level ID by just ΔI1, the switch Q13 goes into the on state again, and as shown in Fig. 4 (4) the switch Q13 is driven in rated current chopper mode. In this interval the switch Q12 is on, but the voltage drop due to the switch Q14 and current detectng resistor R12 is extremely low, so that there is almost no current flow in the solenoid coil SC.

When the energizing command signal goes from a low level to a high level in order to energize the solenoid coil SC, as shown in Fig. 3 (3) the switch Q14 goes instantaneously off for an interval T3, and the current flowing in the coil CC flows in the direction shown by the arrow A13, in other words flows in a circuit in series between the coil CC and the solenoid coil SC. From the well known flux linkage constancy principle of electromagnetism, "Before and after a sudden change in the circuit state, the flux linkage of that circuit is constant", the current I0 of this closed circuit is, if the inductance of the coil CC is Ld, given by the following:

$$IO = \frac{Ld}{Ld + Ls} \cdot ID \qquad \ldots (4)$$

In other words, the current flowing in the coil CC will as shown in Fig. 4 fall instantaneously from the current level ID to the current level I0 shown in (4), and the current flowing in the solenoid coil SC will instantaneously rise to the same level. With existing technology, (equation (1)), the current in the solenoid coil SC rises with time t, but in the present invention, the energizing current of the solenoid coil SC is given an initial energizing value of a proportion of the current level ID of the coil CC immediately before energization corresponding to the inductance of the solenoid coil SC. The result is the time interval for the energizing current to rise can be made substantially shorter. For example, if the inductance of the coil CC and the solenoid coil SC are equal, an initial value of the energizing current of $\frac{1}{2}$ of the current level ID of the coil CC is given by expression (4), and if the inductance of the solenoid coil SC is $\frac{1}{2}$ of the inductance component of the coil CC, then an initial value of the energizing current of $\frac{2}{3}$ of the current level ID will be obtained. Thus according to the present invention, without using a high voltage for the supply voltage Ve the energizing current of the solenoid coil SC can be substantially increased.

After the switch Q14 has been off for an interval T3 as shown in Fig. 4 (5), the switch Q14 returns to the on state, and at the same time, as shown in Fig. 3 (4) the switch Q13 goes off, and the switch Q11 goes on. At this time the current flowing in the coil CC will flow in the direction shown by arrow A14 through the diode CR13 and will decrease. On the other hand, the current flowing in the solenoid coil SC in the interval T1 which is slightly longer than the displacement time of the plunger 2 of the electromagnetic device 1 will flow as shown by the arrow A15 and will increase, and will become greater than the current level I0. Therefore in the present invention yet more speeding up of the movement of the plunger 2 can be obtained. At this point the current paths of the coil CC and the solenoid coil SC are cut off by the diode CR11. When the interval T1 elapses, the current detection resistor R11 detects the current flowing in the solenoid coil SC and according to that detection current value, the switch Q11 turns on/off as shown in Fig 4 (2), and the solenoid coil SC is driven in chopped mode with a rated current of the predetermined holding current level IH. In other words, when the switch Q11 is off, the current flowing in the solenoid coil SC flows, as shown by the arrow A16 in Fig. 3 (5), in the closed circuit of switches Q12 and Q14 and diode CR11, and decreases. At this time the back e.m.f. induced at both ends of the solenoid coil SC is low, there is hardly any current flow in the circuit of the Zener diode ZD1 and diode CR12.

When the energizing command signal changes from the high level to the low level, as shown in Fig. 4 (2) the switch Q11 goes off, and the switch Q14 goes instantaneously to the off state for an interval T4, whereupn the current flowing through the solenoid coil SC flows as shown by the arrow A17 in Fig. 3 (6) through the diode CR13, the coil CC, and the diode CR11. The current Ic in this closed circuit is from the flux linkage constancy principle given by:

$$IC = \frac{Ls}{Ls + Ld} \cdot IH \qquad \ldots (5)$$

That is, when deenergizing, in the reverse way to energizing the solenoid coil SC, the current flowing in the solenoid coil SC falls from the holding current level IH to the current IC. When deenergizing, the current falls instantaneously to $\frac{1}{2}$ of IH if the inductance of the coil CC and the solenoid coil SC are equal, and to $\frac{1}{3}$ of IH if the inductance of the latter is $\frac{1}{2}$ of the inductance of the former. Thereafter, when as shown in Fig. 4 (3) the switch Q12 goes off, the current flowing through the solenoid coil SC in the direction shown by the arrow A18 in Fig. 3 (7) through the closed circuit of the Zener diode ZD1 and diode CR12 decreases rapidly. When the switch Q13 goes on again, the state of Fig. 3 (1) is returned to, and a current flows through the coil CC. The current Ie in Fig. 3 (7) flowing through the solenoid coil SC is given by the following:

$$Ie = IC \cdot e^{-\frac{Ls}{Rs}t} - (1 - e^{-\frac{Ls}{Rs}t}) \cdot \frac{VZ}{Rs} \qquad \ldots (6)$$

Comparing this with expression (2), it will be seen that the de-energisation time is reduced by substantially the ratio of the current level IH and the current level IC.

**Claims**

1. A controller for use with an electromagnetic device in which a movable body (2, 6) is displaced by energising a first coil (SC) via a direct source (E) and in response to a change over command signal (1); said controller comprising a further coil (CC) first series circuit means including a first switch (Q11), the first coil (SC) and a second switch (Q12), a second series circuit means including a third switch (Q13), the further coil (CC) and a fourth switch (Q14), the first and second series means being connected in parallel across the source, third circuit means connected in parallel across the source, the third circuit means including a diode (CR11) connected between the first coil and the further coil and means for controlling the operation of the switches to energise the second circuit means in a chopper mode to cause electromagnetic energy to be stored in the further coil when the first coil is on standby, to transfer energy stored in the further coil (CC) to the first coil (SC) for a predetermined interval ($T_3$) and through the third circuit means when the first coil (SC) is to be energised and thereafter to energise the first circuit means in a chopper mode to maintain the energised state of the first coil (SC) and to transfer energy stored in the first coil to the further coil (CC) for a predetermined time interval ($T_4$) when the first coil (SC) is to be de-energised; characterised in that the energy stored in the first coil (SC) is transferred to the further coil (CC) through said diode.

2. A controller according to claim 1, wherein the control means comprises comparators (CM11, CM12) which receive inputs representing the currents through the coils and current reference values, timers (TM11, TM12) for providing time delayed signals and a series of logic gates which serve to control the operation of the switches.

3. A controller according to claim 2, wherein the control means further comprises edge detectors (ED11, ED12) for detecting changes in the command signal and for operating the gates and timers.

4. A controller according to any one of the preceding claims wherein a further series circuit is connected in parallel with the first coil (SC), said further series circuit comprising a diode (CR2) of polarity opposite to the direction of the energising current and a nonlinear element (ZD1) which conducts when the back e.m.f. produced by the first coil (SC) exceeds a fixed value.

5. A controller according to any one of the preceding claims and further comprising a further diode ($CR_{13}$) connected in parallel with the further coil and the fourth switch.

**Patentansprüche**

1. Steuervorrichtung zur Verwendung in Verbindung mit einer elektromagnetischen Einrichtung, bei der ein beweglicher Körper (2, 6) durch Erregen einer ersten Spule (SC) über eine Gleichspannungsquelle (E) und in Abhängigkeit von einem Umschaltbefehlssignal (1) verschoben wird, wobei die Steuervorrichtung eine weitere Spule (CC) mit einer ersten Reihenschalteinrichtung aufweist, die einen ersten Schalter (Q11), die erste Spule (SC) und einen zweiten Schalter (Q12) umfaßt, die ferner eine zweite Serienschalteinrichtung aufweist, die einen dritten Schalter (Q13), die weitere Spule (CC) und einen vierten Schalter (Q14) umfaßt, wobei die ersten und zweiten Serienschaltungen parallel zu der Versorgungsquelle geschaltet sind, wobei eine dritte Schaltung parallel zu der Versorgungsquelle geschaltet ist und die dritte Schaltung eine Diode (CR11), die zwischen der erste Spule und der weiteren Spule geschaltet ist, und eine Einrichtung zum Steuern der Arbeitsweise der Schalter umfaßt, um die zweite Schaltung gemäß einer Zerhackerbetriebsart zu erregen und um zu bewirken, daß die elektromagnetische Energie in der weiteren Spule gespeichert wird, wenn die erste Spule in Bereitschaft ist, und um die in der weiteren Spule (CC) gespeicherte Energie zu der ersten spule (SC) während eines vorbestimmten Zeitintervalls ($T_3$) und durch die dritte Schaltung zu übertragen, wenn die erste Spule (SC) zu erregen ist, und wobei anschließend die erste Schalteinrichtung gemäß einer Zerhackerbetriebsart betrieben wird, um den Erregungszustand der ersten spule (SC) aufrechtzuerhalten und die in der ersten Spule gespeicherte Energie zu der weiteren Spule (CC) während eines vorbestimmten Zeitintervalls ($T_4$) zu übertragen, wenn die erste Spule (SC) zu erregen ist, dadurch gekennzeichnet, daß die in der erste Spule (SC) gespeicherte Energie zu der weiteren Spule (CC) durch die Diode übertragen wird.

2. Steuervorrichtung nach Anspruch 1, bei der die Steuereinrichtung Komparatoren (CM11, CM12) aufweist, die Eingänge erhalten, welche die Ströme durch die Spulen und die Strombezugswerte wiedergeben, die Zeitgeber (TM11, TM12) zur Bereitstellung von zeitverzögerten Signalen aufweist und die eine Reihe von logischen Verknüpfungselementen aufweist, die zur Steuerung der Arbeitsweise der Schalter dienen.

3. Steuervorrichtung nach Anspruch 2, bei der die Steuereinrichtung ferner Flankendetektoren (ED11, ED12) zum Feststellen von Veränderungen des Befehlssignals und zum Betreiben der Verknüpfungsglieder und der Zeitgeber aufweist.

4. Steuervorrichtung nach einem der vorangehenden Ansprüche, bei der eine weitere Serienschaltung parallel zu der ersten Spule (SC) geschaltet ist, die weitere Serienschaltung eine Diode (CR2) mit einer Polarität aufweist, die zu der Richtung des Erregerstromes entgegengesetzt gerichtet ist, und ein nichtlineares Element (ZD1) aufweist, welches leitend ist, wenn die rückwirkende elektromotorische Kraft, die durch die erste Spule (SC) erzeugt wird, einen fest vorgegebenen Wert überschreitet.

5. Steuervorrichtung nach einem der vorangehenden Ansprüche, welche ferner eine weitere Diode (CR13) aufweist, die parallel zu der weiteren Spule und dem vierten Schalter geschaltet ist.

**Revendications**

1. Dispositif de commande destiné à être utilisé avec un dispositif électromagnétique, dans lequel un corps mobile (2, 6) est déplacé sous l'effet de l'excitation d'une première bobine (SC) par l'intermédiaire d'une source de courant continu (E) et en réponse à un signal de commande d'inversion (1); le dispositif de commande incluant en outre une bobine (CC), des premiers moyens formant circuit série incluant un premier interrupteur (Q11), la première bobine (SC) et un second interrupteur (Q12), des seconds moyens formant circuit série incluant un troisième interrupteur (Q13), l'autre bobine (CC) et un quatrième interrupteur (Q14), les premiers et seconds moyens formant des circuits série étant branchés en parallèle aux bornes de la source, les troisièmes moyens formant circuit incluant une diode (CR11) branchée entre la première bobine et l'autre bobine et des moyens pour commander le fonctionnement des interrupteurs de manière à alimenter les seconds moyens formant circuit selon un mode de fonctionnement en hacheur pour stocker l'énergie électromagnétique dans l'autre bobine lorsque la première bobine est en état d'attente de manière à transférer l'énergie stockée danks l'autre bobine (CC) à la première bobine (SC) pendant un intervalle de temps prédéterminé ($T_3$), et par l'intermédiaire des troisièmes moyens formant circuit lorsque la première bobine (SC) doit être excitée et, ensuite, pour exciter les premiers moyens formant circuit selon un mode de fonctionnement en hacheur pour maintenir l'état excité de la première bobine (SC) et transférer l'énergie stockée dans cette première bobine à l'autre bobine (CC) pendant un intervalle de temps prédéterminé ($T_4$) lorsque la première bobine (SC) doit être désexcitée; caractérisé en ce que l'énergie stockée dans la première bobine (SC) est transférée à l'autre bobine (CC) par l'intermédiaire de ladite diode.

2. Dispositif de commande selon la revendication 1, dans lequel les moyens de commande comprennent des compateurs (CM11, CM12), qui reçoivent des sigmaux d'entrée représentant les courants traversant les bobines et des valeurs de référence des courants, des temporisateurs (TM11, TM12) servant à délivrer des signaux retardés dans le temps, et une série de portes logiques qui servent à commander le fonctionnement des interrupteurs.

3. Dispositif de commande selon la revendication 2, dans lequel les moyens de commande incluent en outre des détecteurs de bords (ED11, ED12) servant à détecter des modifications dans le signal de commande et à actionner les portes et les minuteries.

4. Dispositif de commande selon l'une quelconque des revendications précédentes, dans lequel un autre circuit série est branché en parallèle avec la première bobine (SC), ledit autre circuit série comprenant une diode (CR2) possédant une polarité opposée à la direction du courant d'excitation, et un élément non linéaire (ZD1), qui est conducteur lorsque la force contre-électromotrice produite par la première bobine (SC) dépasse une valeur fixée.

5. Dispositif de commande selon l'une quelconque des revendications précédentes et comprenant en outre une autre diode ($CR_{13}$) branchée en parallèle avec l'autre bobine et le quatrième interrupteur.

FIG. I

# FIG. 2

(1) (2) (3) (4) (5) (6) (7)

FIG. 3

EP 0 184 939 B1

FIG. 4

EP 0 184 939 B1

FIG. 6

FIG. 5

5